# EUROPÄISCHE PATENTSCHRIFT

(11) **EP 3 134 742 B1**
(45) Veröffentlichungstag und Bekanntmachung des Hinweises auf die Patenterteilung: **08.07.2020**
(21) Anmeldenummer: 15722097.1
(22) Anmeldetag: 24.04.2015
(51) Int. Cl.: G01R 1/20, G01R 1/44, G01R 19/00, G01R 19/32

(54) **SHUNTSTROMMESSUNG MIT TEMPERATURKOMPENSATION**
TEMPERATURE CORRECTION FOR CURRENT MEASURING VIA SHUNT
CORRECTION DE TEMPERATURE POUR MESURE DE COURANT VIA SHUNT

(30) Priorität: 24.04.2014 DE 102014207756
(43) Veröffentlichungstag der Anmeldung: 01.03.2017
(73) Patentinhaber: Continental Automotive GmbH, 30165 Hannover (DE)
(72) Erfinder: FRENZEL, Henryk, 93059 Regensburg (DE); AUMER, Andreas, 93133 Burglengenfeld (DE)
(86) Internationale Anmeldenummer: PCT/EP2015/058963
(87) Internationale Veröffentlichungsnummer: WO 2015/162267

(56) Entgegenhaltungen:
- DE-A1-102004 062 655
- DE-A1-102009 044 992
- FR-A1- 2 884 615

## Beschreibung

Die Erfindung betrifft ein Verfahren zum Messen eines Stromes mit einem Stromsensor.

Elektrische Ströme in und aus einer Fahrzeugbatterie werden beispielsweise in der DE 10 2009 044 992 A1 und in der DE 10 2004 062 655 A1 mit einem Stromsensor über einen Messwiderstand, auch Shunt genannt, gemessen. Um die Genauigkeit der Strommessung zu erhöhen, wird in beiden Fällen vorgeschlagen, einen durch die am Messwiderstand abfallende Verlustleistung bedingten Temperaturanstieg zu kompensieren, um Thermospannungen zu vermeiden. Dazu wird auf den Temperaturanstieg von der Verlustleistung aus geschlossen.

Es ist Aufgabe der vorliegenden Erfindung das bekannte Verfahren zur Strommessung zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein Verfahren zum Messen eines aus einer Fahrzeugbatterie abgegebenen und über einen elektrischen Messwiderstand geleiteten elektrischen Stromes, die Schritte Erfassen einer über dem Messwiderstand abfallenden elektrischen Messspannung; Ermitteln einer Temperaturdifferenz zwischen zwei in Strömungsrichtung des elektrischen Stromes räumlich beabstandeten Temperaturpunkten zwischen denen wenigstens ein Teil des elektrischen Messwiderstands liegt; und Bestimmen des elektrischen Stromes basierend auf der erfassten elektrischen Messspannung und der ermittelten Temperaturdifferenz.

Dem angegebenen Verfahren liegt die Überlegung zugrunde, dass die eingangs genannten Kompensationen von Temperaturänderungen vorgenommen werden, um Messfehler zu korrigieren. Diese rühren aus der Thermospannung her, die den vom elektrischen Strom am Messwiderstand verursachten Spannungsabfall verfälscht, so dass der gemessene elektrische Strom ebenfalls fehlerbehaftet ist. Durch die Kompensation der Temperaturänderung können die Fehler bei der Strommessung zwar wirksam reduziert werden, jedoch breiten sich Temperaturänderungen prinzipiell sehr langsam aus. Das hat zur Folge, dass die Kompensation der Temperatur immer erst mit einer gewissen Verzögerung oder Totzeit greift. Das ist aber aus dem Messwert für den gemessenen Strom nicht ersichtlich, weshalb der Strom während der Totzeit immer noch fehlerhaft erfasst wird.

Hier greift das angegebene Verfahren mit der Überlegung an, nicht die Ursache in der fehlerhaften Strommessung, das heißt die Temperaturänderung sondern ihre Auswirkungen, das heißt die Thermospannung selbst zu kompensieren. Ein mit einem Messwiderstand ausgestatteter Stromsensor erfasst den zu messenden Strom basierend auf einem Spannungsabfall am Messwiderstand, wobei der zu messende Strom basierend auf den elektrischen Eigenschaften des Messwiderstandes und dem erfassten Spannungsabfall eindeutig über bekannte elektrotechnische Gesetzte bestimmbar ist. Zusätzlich wird die der Thermospannung zugrundeliegende Ursache, also die Temperaturdifferenz über zwei lokal beabstandete Punkte in der Messstrecke ermittelt. Bei der Berechnung des elektrischen Stromes basierend auf dem Spannungsabfall kann dann die Temperaturdifferenz berücksichtigt werden, um den elektrischen Strom zu korrigieren.

Durch die Korrektur des elektrischen Stromes basierend auf der ermittelten Temperaturdifferenz kann der gemessene Strom unmittelbar, ohne eine Totzeit von der Thermospannung bereinigt werden, wodurch fehlerfreie Messdaten schneller vorliegen.

Zwar kann die Korrektur des elektrischen Stromes basierend auf der ermittelten Temperaturdifferenz beliebig durchgeführt werden, in einer bevorzugten Weiterbildung umfasst das angegebene Verfahren jedoch die Schritte Bestimmen einer elektrischen Korrekturspannung basierend auf der ermittelten Temperaturdifferenz; Korrigieren der elektrischen Messspannung basierend auf der elektrischen Korrekturspannung und Bestimmen des elektrischen Stromes basierend auf der korrigierten elektrischen Messspannung. Die elektrische Korrekturspannung sollte zweckmäßigerweise mit der oben erläuterten Thermospannung in Verbindung stehen und so nahe wie möglich an diese angenähert werden. Die Korrektur des erfassten Spannungsabfalls, also der elektrischen Messspannung mit der Thermospannung, kann dann durch eine technisch einfache Beaufschlagung der elektrischen Messspannung mit der Korrekturspannung erfolgen, was insbesondere Rechenressourcen spart.

Die elektrische Korrekturspannung kann dabei in beliebiger Weise bestimmt werden. So können beispielsweise physikalische Gesetzte herangezogen werden, um die elektrische Korrekturspannung basierend auf der ermittelten Temperaturdifferenz analytisch oder numerisch zu bestimmten. Das ist jedoch in der Regel nur schwer mit einem vertretbaren Aufwand möglich. Daher ist in einer bevorzugten Weiterbildung des angegebenen Verfahrens die elektrische Korrekturspannung in einer Kennlinie über die ermittelte Temperaturdifferenz aufgetragen ist. Aus dieser Kennlinie kann dann die elektrische Korrekturspannung basierend auf der Temperaturdifferenz ausgelesen werden. Die Kennlinie kann beispielsweise vorab rechnerisch und/oder experimentell dadurch bestimmt werden, dass am Messwiderstand eine definierte Temperaturdifferenz eingetragen und die daraus resultierende Thermospannung ermittelt wird. Die Kennlinie kann dann mit wenig Aufwand in einem Speicher hinterlegt und im Einsatz zeitnah ausgelesen werden.

Die Temperaturdifferenz zwischen den Temperaturpunkten lässt sich im Prinzip beliebig ermitteln. Hierzu können die Temperaturen an den beiden Temperaturpunkten beispielsweise geschätzt und/oder gemessen und anschließend die Temperaturdifferenz durch Subtrahieren der beiden ermittelten Temperaturen voneinander bestimmt werden. Dabei kann beispielsweise auch die Temperatur an nur einem Temperaturpunkt gemessen und die Temperatur am anderen Temperaturpunkt geschätzt werden.

In einer zusätzlichen Weiterbildung des angegebenen Verfahrens liegen die Temperaturpunkte in Strömungsrichtung des elektrischen Stromes betrachtet vor und nach dem elektrischen Messwiderstand. Auf diese Weise werden alle stofflichen Leitungsübergänge in der Stromleitung, an denen prinzipiell eine Thermospannung auftreten kann, mit in das angegebene Verfahren eingebunden, so dass der elektrische Strom mit dem angegebenen Verfahren besonders genau ermittelbar ist. Prinzipiell reicht es jedoch, wenn die Temperaturdifferenz nur über einen einzigen stofflichen Leitungsübergang erfasst wird, um mit dem Verfahren eine Reduktion von Fehlern im gemessenen elektrischen Strom zu erreichen.

In einer weiteren Weiterbildung des angegebenen Verfahrens ist wenigstens ein Temperaturpunkt auf der Oberfläche eines den elektrischen Strom führenden elektrischen Leiters angeordnet, so dass die ermittelte Temperaturdifferenz besonders nahe an der für die Thermospannung relevanten Temperaturdifferenz ist und so der Fehler im gemessenen elektrischen Strom weiter reduziert werden kann.

In einer anderen Weiterbildung des angegebenen Verfahrens wird die Temperatur auf der Oberfläche des den elektrischen Strom führenden elektrischen Leiters optisch erfasst wird. Insbesondere kann dabei die Erfassung über Infrarotsensoren zum Einsatz kommen. Auf diese Weise lässt sich die Temperatur auf der Oberfläche berührungslos erfassen und die Temperaturdifferenz entsprechend genau messen.

Insbesondere, wenn die Temperatur nicht direkt auf der Oberfläche des von zu messenden Strom durchflossenen elektrischen Leiters erfasst wird, kann zum Ermitteln der Temperaturdifferenz zwischen den Temperaturpunkten eine Temperatur an wenigstens einem Temperaturpunkt gemessen und vor dem Ermitteln der Temperaturdifferenz um einen vorbestimmten Totzeitbetrag verzögert werden. Auf diese Weise wird die Verzögerung bei der Wärmeausbreitung aufgrund der nicht unendlich hohen Wärmeleitfähigkeit der einzelnen Komponenten des Stromsensors, wie zum Beispiel die Anschlusspins, die Leiterplatte und/oder die Luft berücksichtigt.

In einer noch anderen Weiterbildung des angegebenen Verfahrens wird die Temperatur an beiden Temperaturpunkten gemessen und zum Ermitteln der Temperaturdifferenz zwischen den Temperaturpunkten mit einem Differenzenverstärker verstärkt. Auf diese Weise wird die Temperaturdifferenz mit einer ausreichend hohen Amplitude aufgenommen, wodurch ein hoher Signal-Rauschbandabstand erreicht und Messfehler reduziert werden.

Gemäß einem weiteren Aspekt der Erfindung ist eine Steuervorrichtung eingerichtet, ein Verfahren nach einem der vorstehenden Ansprüche durchzuführen.

In einer Weiterbildung der angegebenen Steuervorrichtung weist die angegebene Vorrichtung einen Speicher und einen Prozessor auf. Dabei ist das angegebene Verfahren in Form eines Computerprogramms in dem Speicher hinterlegt und der Prozessor zur Ausführung des Verfahrens vorgesehen, wenn das Computerprogramm aus dem Speicher in den Prozessor geladen ist.

Gemäß einem weiteren Aspekt der Erfindung umfasst ein Computerprogramm Programmcodemittel, um alle Schritte eines der angegebenen Verfahren durchzuführen, wenn das Computerprogramm auf einem Computer oder einer der angegebenen Vorrichtungen ausgeführt wird.

Gemäß einem weiteren Aspekt der Erfindung enthält ein Computerprogrammprodukt einen Programmcode, der auf einem computerlesbaren Datenträger gespeichert ist und der, wenn er auf einer Datenverarbeitungseinrichtung ausgeführt wird, eines der angegebenen Verfahren durchführt.

Gemäß einem anderen Aspekt der Erfindung umfasst ein Stromsensor zum Messen eines elektrischen Stromes einen elektrischen Messwiderstand, über den der zu messende elektrische Strom führbar ist eine der angegebenen Steuervorrichtungen.

Gemäß einem anderen Aspekt der Erfindung umfasst ein Fahrzeug eine der angegebenen Steuervorrichtungen und/oder den angegebenen Stromsensor.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine Prinzipdarstellung eines Fahrzeuges mit einem elektrischen Antrieb;
Fig. 2 eine Prinzipdarstellung eines Stromsensors aus dem Fahrzeuges der Fig. 1;
Fig. 3 einen Schaltplan des Stromsensors der Fig. 2;
Fig. 4 Veränderungen der Strommessergebnisse des Stromsensors der Fig. 3 über die Temperatur; und

In den Figuren werden gleiche technische Elemente mit gleichen Bezugszeichen versehen und nur einmal beschrieben.

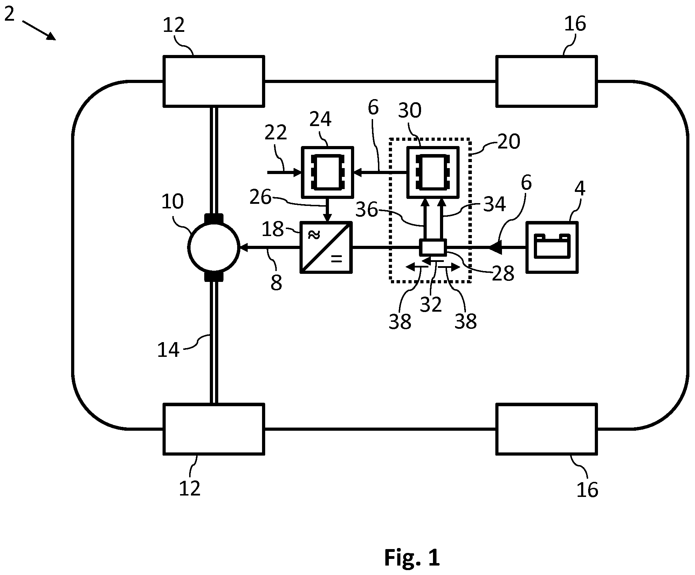

Es wird auf Fig. 1 Bezug genommen, die eine Prinzipdarstellung eines Fahrzeuges 2 mit einer Fahrzeugbatterie 4 zeigt, aus der ein elektrischer Strom 6 abgegeben wird.

Mit dem elektrischen Strom 6 werden in dem Fahrzeug 2 verschiedene elektrische Verbraucher mit elektrischer Energie 8 versorgt.

Ein Beispiel für diese elektrischen Verbraucher ist ein Elektromotor 10, der mit der elektrischen Energie 8 die Vorderräder 12 des Fahrzeuges 2 über eine Antriebswelle 14 antreibt. Die Hinterräder 16 des Fahrzeuges 2 sind daher freilaufende Räder. Derartige, zum Antrieb des Fahrzeuges 2 verwendete Elektromotoren 10 werden in der Regel als Wechselstrommotoren ausgelegt, während der elektrische Strom 6 aus der Fahrzeugbatterie 4 ein Gleichstrom ist. In diesem Fall muss der elektrische Strom 6 zunächst über einen Konverter 18 in einen Wechselstrom gewandelt werden.

In Fahrzeugen, wie dem Fahrzeug 2 wird in der Regel ein Stromsensor 20 verbaut, der den von der Fahrzeugbatterie 4 abgegebenen elektrischen Strom 6 misst. Basierend auf dem gemessenen elektrischen Strom 6 können dann verschiedene Funktionen realisiert werden. Zu diesen gehören beispielsweise Schutzfunktionen, wie aus der DE 20 2010 015 132 U1 bekannt, mit denen die Fahrzeugbatterie 4 beispielsweise vor einer Tiefenentladung geschützt werden kann.

Entspricht der mit dem Stromsensor 2 gemessene Strom 6 nur dem elektrischen Strom, der dem Konverter 18 zugeführt wird, kann dieser auch zur Regelung der Antriebsleistung des Fahrzeuges 2 verwendet werden. Die Antriebsleistung wird in der Regel über vom Fahrer des Fahrzeuges 2 mit einem Fahrerwunsch 22 vorgegeben. Eine Motorsteuerung 24 vergleicht dann einen aus dem Fahrerwunsch resultierenden elektrischen Sollstrom mit dem gemessenen elektrischen Strom 6 und steuert den Konverter 18 mit Steuersignalen 26 derart an, dass der gemessene elektrische Strom 6 an den aus dem Fahrerwunsch resultierenden Sollstrom angeglichen wird. Derartige Regelungen sind bestens bekannt und sollen daher nicht weiter vertieft werden.

Der Stromsensor 20 umfasst einen vorzugsweise als Messwiderstand 28, auch Shunt genannt, ausgebildeten Messaufnehmer und eine Auswerteeinrichtung 30. Der Messwiderstand 28 wird im Rahmen der vorliegenden Ausführung vom elektrischen Strom 6 durchströmt, was zu einem Spannungsabfall 32 an dem Messwiderstand 28 führt. Dieser Spannungsabfall 32 wird als Messspannung durch die Auswerteeinrichtung 30 über ein in Richtung des elektrischen Stromes 6 gesehenes, eingangsseitiges elektrisches Potential 34 am Messwiderstand 28 und ein ausgangsseitiges elektrisches Potential 36 am Messwiderstand 28 erfasst. Aus diesen beiden elektrischen Potentialen 34, 36 berechnet die Auswerteeinrichtung 30 den Spannungsabfall 32 und über den Widerstandswert des Messwiderstandes 28 den elektrischen Strom 6, der durch den Messwiderstand 28 fließt.

Der Messwiderstand 28 unterscheidet sich als elektrischer Leiter in der Regel von den übrigen elektrischen Leitern, die den elektrischen Strom 6 von der Fahrzeugbatterie 4 zum Konverter 18 führen. Bekanntermaßen ruft der thermoelektrische Effekt, auch Seeback-Effekt genannt, zwischen einem Materialübergang in einem elektrischen Leiter, der in einem Temperaturgefälle, also einer Temperaturdifferenz liegt, eine Thermospannung hervor. Ein derartiger Materialübergang ist aufgrund des Messwiderstandes 28 am Stromsensor 20 eingangsseitig und ausgangsseitig vorhanden. Eine Temperaturdifferenz entsteht prinzipbedingt, weil sich der Messwiderstand 28 aufgrund von durch den elektrischen Strom 6 hervorgerufenen elektrischen Verlustleistungen erwärmt. Die so entstehenden Thermospannungen 38 addierend sich zum Spannungsabfall 32 und verfälschen somit die Messung des elektrischen Stromes 6.

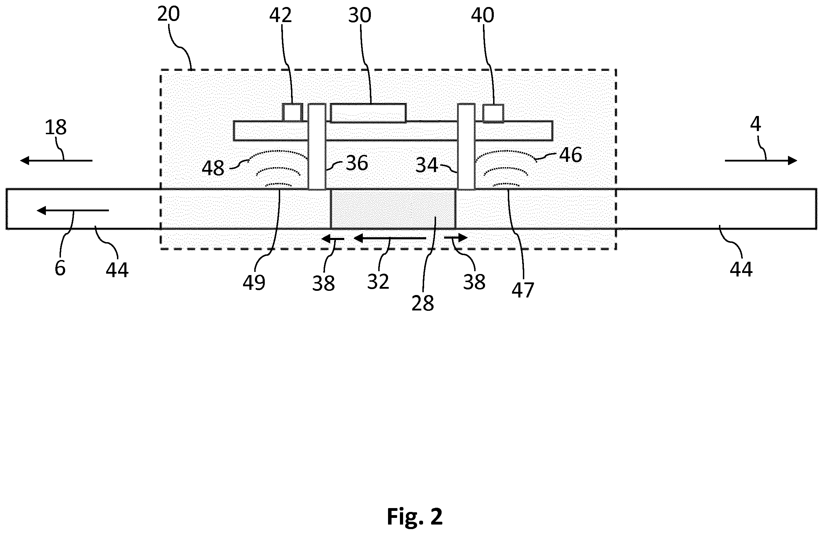

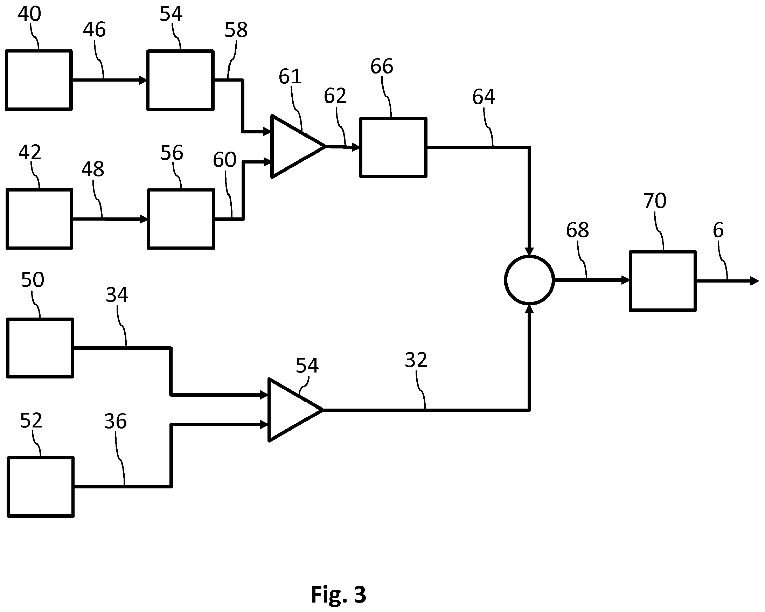

Daher wird im Rahmen der vorliegenden Ausführung vorgeschlagen, die Messung des elektrischen Stromes 6 um die Thermospannungen 38 zu korrigieren. Dies erfolgt im Rahmen der vorliegenden Ausführung innerhalb der Auswerteeinrichtung 30 uns soll nachstehend beschrieben werden:
Es wird auf Fig. 2 und 3 Bezug genommen, die entsprechend den Stromsensor 20 in einer schematischen Darstellung gemäß einem ersten Ausführungsbeispiel und ein Ablaufdiagramm zeigen, das bei der Messung des Stromes 6 im Stromsensor 20 durchgeführt werden kann.

Im Rahmen der vorliegenden Ausführung sind auf dem Stromsensor 20 ein erster Temperatursensor 40 und ein zweiter Temperatursensor 42 angeordnet, die in Stromrichtung des elektrischen Stromes 6 betrachtet entsprechend die Temperatur 46, 48 des den elektrischen Strom führenden Leiters 44 an einem Temperaturpunkt 47 vor und an einem Temperaturpunkt 49 nach dem Messwiderstand 28 messen.

Zur Messung des Stromes 6 können zunächst die beiden elektrischen Potentiale 34, 36 mit entsprechenden Spannungsmessern 50, 52 gemessen werden, die die elektrischen Potentiale 34, 36 als elektrische Spannung gegenüber einem Referenzpotential, wie beispielsweise Masse messen. Die gemessenen elektrischen Potentiale 34, 36 können dann in einem Differenzenverstärker 54, wie beispielsweise einem Operationsverstärker voneinander abgezogen und gleichzeitig verstärkt, und so der Spannungsabfall 32 berechnet werden. Auf diese Weise steht der Spannungsabfall 32 als Grundlage zur Bestimmung des elektrischen Stromes 6 zur Verfügung.

Wie bereits erläutert soll dieser vor der Bestimmung des elektrischen Stromes 6 jedoch um die Thermospannungen 38 korrigiert werden. Aus diesem Grund werden die eingangsseitige Temperatur 46 und die ausgangsseitige Temperatur 48 am Messwiderstand 28 erfasst. Da die Ausbreitung der Temperaturen 46, 48 bis zu den entsprechenden Temperatursensoren 40, 42 eine bestimmte Zeit dauert, sind im Rahmen der vorliegenden Ausführung weiter Verzögerungsglieder 54, 56 vorhanden, die die gemessenen Temperaturen 46, 48 um diese Verzögerungszeiten verzögern. Damit die Verzögerungszeiten, auch Totzeiten genannt, für jede Temperatur 46, 48 individuell eingestellt werden kann, ist für jede Temperatur 46, 48 ein eigenes Verzögerungsglied 54, 56 angeordnet.

Die entsprechend verzögerten Temperaturen 58, 60 werden dann beispielsweise mit einem Differenzenverstärker 61 voneinander subtrahiert, so dass die Temperaturdifferenz 62 zwischen den Messpunkten bekannt ist, an denen die Temperaturen 46, 48 gemessen wurden.

Aus dieser Temperaturdifferenz 62 wird abschließend eine Korrekturspannung 64 bestimmt, die von den beiden Thermospannungen 38 abhängig ist. Im vorliegenden Ausführungsbeispiel ist dafür eine Kennlinie 66 vorhanden, im Rahmen derer jeder Temperaturdifferenz 62 eindeutig eine Korrekturspannung 64 zugeordnet ist. Diese Kennlinie 66 kann beispielsweise vorab experimentell und/oder analytisch bestimmt werden. Zur experimentellen Bestimmung der Kennlinie 66 kann beispielsweise versuchsweise der Spannungsabfall 32 am Messwiderstand 28 als Korrekturspannung 64 gemessen werden, ohne dass der Messwiderstand 28 vom Strom 6 durchflossen wird.

Der Spannungsabfall 32 wird dann zur Korrektur mit der Korrekturspannung 64 beaufschlagt. Der so korrigierte Spannungsabfall 68 kann dann in einer entsprechenden Umrechnungseinrichtung 70 in den gesuchten Strom 6 in an sich bekannter Weise umgerechnet werden.

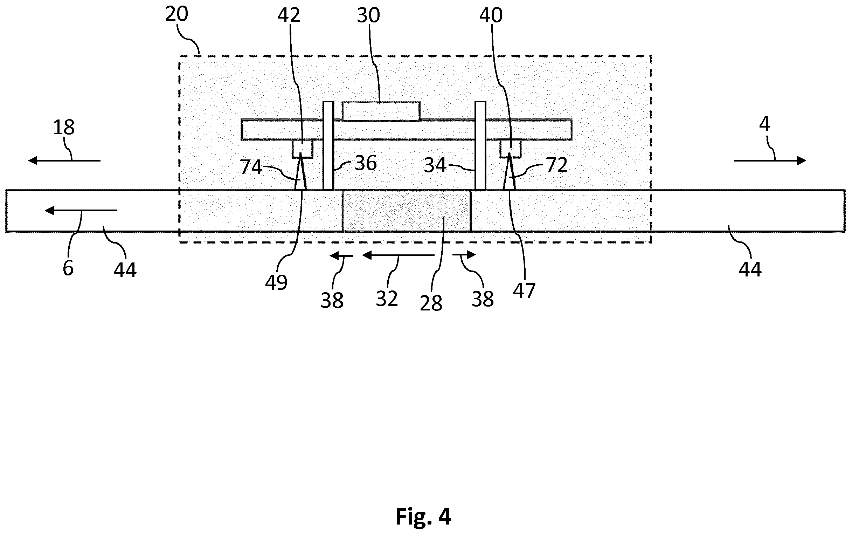

Im Rahmen des in Fig. 4 gezeigten Stromsensors 20 können die Temperaturen 46, 48 auch direkt an der Oberfläche des elektrischen Leiters 44, beispielsweise optisch erfasst werden. Hierzu sind die Temperatursensoren 40, 42 als optische Sensoren und insbesondere als Infrarotsensoren ausgebildet, die die Temperaturen 46, 48 über entsprechende durch die Temperaturen 46, 48 verursachte Infarotstrahlungen 72, 74 erfassen.

Auf diese Weise werden die Temperaturen 46, 48 zeitlich unmittelbar erfasst, so dass auf die in Fig. 3 gezeigten Verzögerungsglieder 54, 56 gegebenenfalls ganz verzichtet werden kann.

## Patentansprüche

1. Verfahren zum Messen eines aus einer Fahrzeugbatterie (4) abgegebenen und über einen elektrischen Messwiderstand (28) geleiteten elektrischen Stromes (6), umfassend:
- Erfassen einer über dem Messwiderstand (28) abfallenden elektrischen Messspannung (32);
das Verfahren ist **gekennzeichnet durch**
- Ermitteln einer Temperaturdifferenz (62) zwischen zwei in Strömungsrichtung des elektrischen Stromes (6) räumlich beabstandeten Temperaturpunkten (47, 49) zwischen denen wenigstens ein Teil des elektrischen Messwiderstands (28) liegt; und
- Bestimmen des elektrischen Stromes (6) basierend auf der erfassten elektrischen Messspannung (32) und der ermittelten Temperaturdifferenz (62).

2. Verfahren nach Anspruch 1, umfassend:
- Bestimmen einer elektrischen Korrekturspannung (64) basierend auf der ermittelten Temperaturdifferenz (62);
- Korrigieren der elektrischen Messspannung (32) basierend auf der elektrischen Korrekturspannung (64); und
- Bestimmen des elektrischen Stromes (6) basierend auf der korrigierten elektrischen Messspannung (68).

3. Verfahren nach Anspruch 2, wobei die elektrische Korrekturspannung (64) in einer Kennlinie (66) über die ermittelte Temperaturdifferenz (62) aufgetragen ist.

4. Verfahren nach einem der vorstehenden Ansprüche, wobei die Temperaturpunkte (47, 49) in Strömungsrichtung des elektrischen Stromes (6) betrachtet vor und nach dem elektrischen Messwiderstand (28) liegen.

5. Verfahren nach Anspruch 4, wobei wenigstens ein Temperaturpunkt (47, 49) auf der Oberfläche eines den elektrischen Strom (6) führenden elektrischen Leiters (44) angeordnet ist.

6. Verfahren nach Anspruch 5, wobei eine der Temperaturdifferenz (62) zugrundeliegende Temperatur (46, 48) auf der Oberfläche des den elektrischen Strom (6) führenden elektrischen Leiters (44) optisch erfasst wird.

7. Verfahren nach einem der vorstehenden Ansprüche, wobei zum Ermitteln der Temperaturdifferenz (62) zwischen den Temperaturpunkten (47, 49) eine Temperatur (46, 48) an wenigstens einem Temperaturpunkt (47, 49) gemessen und vor dem Ermitteln der Temperaturdifferenz (62) um einen vorbestimmten Totzeitbetrag (54, 56) verzögert wird.

8. Verfahren nach einem der vorstehenden Ansprüche, wobei eine Temperatur (46, 48) an beiden Temperaturpunkten (47, 49) gemessen und zum Ermitteln der Temperaturdifferenz (62) zwischen den Temperaturpunkten (47, 49) mit einem Differenzenverstärker (61) verstärkt wird.

9. Stromsensor (20) zum Messen eines elektrischen Stromes (6), umfassend:
- einen elektrischen Messwiderstand (28), über den der zu messende elektrische Strom (6) führbar ist,
- eine Steuervorrichtung (30), die eingerichtet ist, ein Verfahren nach einem der vorstehenden Ansprüche durchzuführen.

## Claims

1. Method for measuring an electrical current (6) delivered from a vehicle battery (4) and conducted via an electrical measuring resistor (28), comprising:
- recording an electrical measurement voltage (32) dropped across the measuring resistor (28);
the method **characterized by**
- determining a temperature difference (62) between two temperature points (47, 49) which are spatially at a distance in the direction of flow of the electrical current (6) and between which at least one part of the electrical measuring resistor (28) lies; and
- determining the electrical current (6) based on the recorded electrical measurement voltage (32) and the determined temperature difference (62).

2. Method according to Claim 1, comprising:
- determining an electrical correction voltage (64) based on the determined temperature difference (62);
- correcting the electrical measurement voltage (32) based on the electrical correction voltage (64); and
- determining the electrical current (6) based on the corrected electrical measurement voltage (68).

3. Method according to Claim 2, the electrical correction voltage (64) being plotted against the determined temperature difference (62) in a characteristic curve (66).

4. Method according to one of the preceding claims, the temperature points (47, 49) lying upstream and downstream of the electrical measuring resistor (28) in the direction of flow of the electrical current (6).

5. Method according to Claim 4, at least one temperature point (47, 49) being arranged on the surface of an electrical conductor (44) carrying the electrical current (6).

6. Method according to Claim 5, a temperature (46, 48) on which the temperature difference (62) is based being optically recorded on the surface of the electrical conductor (44) carrying the electrical current (6).

7. Method according to one of the preceding claims, wherein, in order to determine the temperature difference (62) between the temperature points (47, 49), a temperature (46, 48) at at least one temperature point (47, 49) is measured and is delayed by a predetermined dead time (54, 56) before determining the temperature difference (62).

8. Method according to one of the preceding claims, a temperature (46, 48) at both temperature points (47, 49) being measured and being amplified using a differential amplifier (61) in order to determine the temperature difference (62) between the temperature points (47, 49).

9. Current sensor (20) for measuring an electrical current (6), comprising:
- an electrical measuring resistor (28) via which the electrical current (6) to be measured can be carried,
- a control apparatus (30) which is configured to carry out a method according to one of the preceding claims.

## Revendications

1. Procédé de mesure d'un courant électrique (6) délivré par une batterie de véhicule (4) et conduit par une résistance de mesure (28) électrique, comprenant :
- acquisition d'une tension de mesure (32) électrique qui chute aux bornes de la résistance de mesure (28) ; le procédé est **caractérisé par**
- identification d'une différence de température (62) entre deux points de température (47, 49), espacés dans l'espace dans le sens de circulation du courant électrique (6), entre lesquels se trouve au moins une partie de la résistance de mesure (28) électrique ; et
- détermination du courant électrique (6) en se basant sur la tension de mesure (32) électrique acquise et la différence de température (62) identifiée.

2. Procédé selon la revendication 1, comprenant :
- détermination d'une tension de correction (64) électrique en se basant sur la différence de température (62) identifiée ;
- correction de la tension de mesure (32) électrique en se basant sur la tension de correction (64) électrique ; et
- détermination du courant électrique (6) en se basant sur la tension de mesure électrique corrigée (68).

3. Procédé selon la revendication 2, la tension de correction (64) électrique étant tracée dans une courbe caractéristique (66) en fonction de la différence de température (62) identifiée.

4. Procédé selon l'une des revendications précédentes, les points de température (47, 49), vu dans le sens de circulation du courant électrique (6), se trouvant avant et après la résistance de mesure (28) électrique.

5. Procédé selon la revendication 4, au moins un point de température (47, 49) étant disposé sur la surface d'un conducteur électrique (44) qui conduit le courant électrique (6).

6. Procédé selon la revendication 5, une température (46, 48) sur laquelle se base la différence de température (62) étant détectée optiquement sur la surface d'un conducteur électrique (44) qui conduit le courant électrique (6).

7. Procédé selon l'une des revendications précédentes, selon lequel, en vue d'identifier la différence de température (62) entre les points de température (47, 49), une température (46, 48) est mesurée en au moins un point de température (47, 49) puis retardée d'une valeur de temps mort (54, 56) prédéterminée avant l'identification de la différence de température (62).

8. Procédé selon l'une des revendications précédentes, une température (46, 48) aux deux points de température (47, 49) étant mesurée puis amplifiée par un amplificateur différentiel (61) en vue d'identifier la différence de température (62) entre les points de température (47, 49).

9. Capteur de courant (20) destiné à mesurer un courant électrique (6), comprenant :
- une résistance de mesure (28) électrique par laquelle peut être conduit le courant électrique (6) à mesurer,
- un dispositif de commande (30) qui est conçu pour mettre en œuvre un procédé selon l'une des revendications précédentes.
